(19) Europäisches Patentamt / European Patent Office / Office européen des brevets

(11) **EP 3 301 300 A1**

(12) **EUROPEAN PATENT APPLICATION**

(43) Date of publication:
04.04.2018 Bulletin 2018/14

(51) Int Cl.:
*F04B 39/00* (2006.01)

(21) Application number: 17193744.4

(22) Date of filing: 28.09.2017

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR
Designated Extension States:
BA ME
Designated Validation States:
MA MD

(30) Priority: 30.09.2016 BR 102016022894
25.09.2017 BR 102017020421

(71) Applicant: Huangshi Dongbei Electrical Appliance
Co., Ltd.
Huangshi, Hubei 435006 (CN)

(72) Inventor: SILVEIRA, MARCIO
89223-270 Joinville, Santa Catarina (BR)

(74) Representative: Maiwald Patentanwalts GmbH
Engineering
Elisenhof
Elisenstrasse 3
80335 München (DE)

(54) **RESONATOR ELEMENT IN A SUCTION FILTER FOR HERMETIC COMPRESSOR AND METHOD OF MANUFACTURE OF A RESONATOR ELEMENT**

(57) This invention refers to a suction filter (B) for hermetic compressor of type "variable speed" comprised, preferably of an arrangement of a volume (5), two tubes (1, 2), an inlet nozzle (3) and an outlet nozzle (4), having an internal resonant system, in which is positioned a set (10) of ducts (9), these having variable length. Different lengths represent different tunings for each frequency band of interest, and the fixed diametrical dimension having an perimeter extension at the base of the suction filter (B), the perimeter extension having an extension greater than or equal to the resonant tube (9), but smaller than or equal to the length of the tube. In the suction filter of the present invention the resonators (9) and the position of them are determined by the need for attenuation of the filter without introducing losses to the pulsating flow in the filter. The suction filter (B) is determined by the fact that the main tubes have a geometric correlation with the resonating tubes (9) producing the desired attenuation effect without affecting the other performance characteristics of the compressor.

Figure 5

EP 3 301 300 A1

Printed by Jouve, 75001 PARIS (FR)

## Description

## TECHNICAL FIELD

The present invention refers to an acoustic filter arrangement for a suction system used in refrigeration variable capacity hermetic compressors or conventional.

## DESCRIPTION OF THE PRIOR ART

Variable capacity hermetic compressors normally use a suction system of the direct, indirect, or semi-direct suction type, depending on the refrigerant and the conditions of application. The said suction system is composed of suction hole, which can be only one or multiple; suction valve, which are designed according to the suction holes and the acoustic filter also called suction filter. The suction filter is usually made of plastic, and operates in the current hermetic compressors as a noise reducer through the load loss provided to the refrigerant gas during the compression process.

The suction system is responsible for conducting the refrigerant gas that returns from the cooling system to the compressor, so that it is again compressed in order to carry out the complete process of the cooling cycle. In the suction system, the suction filter is normally coupled to the suction hole and to the suction valve, through a fixing spring located on the cylinder lid in order to avoid leaks to the discharge system and/or to the compressor cavity.

Hermetic compressors for refrigeration are used in freezers, refrigerators, watercoolers, air conditioners and other applications. An important characteristic of the compressors is their acoustic performance, for there is a maximum acceptable value for the noise generated by the compressor when applied to the refrigerator.

Depending on the region and the country of commercialization, each manufacturer defines a maximum acceptable noise value for its system. This maximum noise level is divided by capacity, i.e., higher-capacity cooling systems generate more noise, which ends up defining a higher threshold. For example, typical systems with capacity between 200 and 250 W present a total maximum noise threshold around 40 dBA.

Another very important characteristic is the thermal performance, for it defines an energy efficiency needed to achieve the energy consumption objectives of the system, and thus the more efficient the compressor, the greater will be the energy saving of the cooling system. The filter also aids the thermal insulation of the gas, as it creates a separate volume of the internal cavity of the compressor, which is usually hotter for being in contact with the discharge system. The filter protects the gas from this internal heating from the compressor. Thus, it is desirable that the performance of the compressor, and primarily its efficiency, to be the greatest as possible, in order to maximize the use of the product in high-yield cooling systems, allowing to achieve the power consumption regulations and, effectively, save energy to the final consumer.

As verified from the reading of the documents WO 2000/052333 A1, WO 2011/147005 A1 and WO 2008/098330, it can be observed that for increasing acoustic attenuation it is necessary to decrease the diameters and increase the lengths of the tubes, thereby causing an unwanted increase in load loss.

The present invention differs from the previous prior art in how it improves the filter's response, which is achieved by an acoustic attenuation by the use of a set of resonators, which avoid the increase in flow restriction (load loss) to obtain significant noise attenuation. The presence of the set of resonators positioned in the filter volume causes only the effect of cancellation of waves in specific frequency bands without increasing the original load loss of the filter.

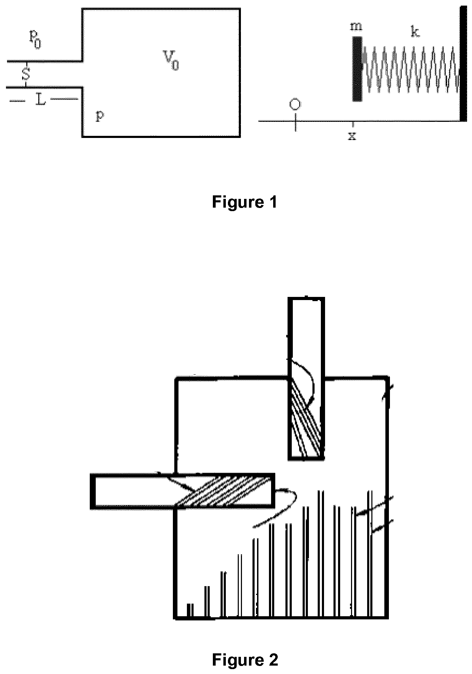

Also known are solutions of reactive-type acoustic filter comprising a set of resonators disposed along the inlet and outlet ducts of the filter (Brazilian Patent Application PI 0601716-9), particularly an arrangement of circular resonators preferably disposed in the ducts and in the lower part of the filter body. Figure 2 illustrates an arrangement construct of the resonators of the aforementioned technique.

Although this solution minimizes the noise produced by the gas passing through the respective acoustic filter, the positioning of the said tubes in the lower part of the filter causes the loss of primordial function due to the presence of oil and liquid refrigerant during the compressor operation. Moreover, the ducts used therein do not have regular and harmonically increasing or decreasing sizes, but rather varying sizes in a deformed manner and without any harmony in relation to one another. The lack of a harmonic sizing of the ducts harms the compressor's yield, as it creates turbulence, preventing the refrigerant from properly and efficiently passing through the filter volume.

With regard to the phenomenon that is desired to attenuate, it is noted that resonance is a phenomenon that is peculiar to oscillating systems. A known example of resonance occurs between a crystal glass of sparkling and an opera singer. If someone produces a slight beat on a glass with a spoon, it produces a musical note. This is the natural frequency of vibration of the glass. If a singer is capable of intoning precisely this frequency, the glass will absorb the sound energy and break. Every sound wave is capable of producing vibrations that stimulate oscillations on bodies located near the sources.

Therefore, when the oscillation frequency of the source coincides with the frequency of natural oscillation of the body, the amplitude of oscillation of that body reaches high values. This phenomenon is known as resonance.

Natural frequency of a body: it is the set of particular frequencies of a body and depends on a set of factors such as elasticity, material and body shape.

With that, it can be explained what resonance is. It happens when the frequency of a oscillation source coincides with the natural frequency of the body, thereby generating nodes and anti-nodes with a high amplitude. This causes the object to vibrate with a greater intensity. An example of electronic resonance occurs when we tune a radio to an appropriate frequency to receive the transmitter signal.

A stationary wave occurs when two waves travel in opposite directions through the same medium. This is the result of two-wave interference. In some points, called nodes, the interference is completely destructive. In other points, called anti-nodes the waves are amplified by the overlap of the waves, which is called constructive interference.

In the case of sound waves, the pressure varies as the molecules are arranged in their equilibrium position.

The thermal performance of the compressor is mainly dictated by the ability to compress the refrigerant at low temperature without introducing significant load losses to the process. Therefore, it is necessary the energy efficiency to be maximized, but at the same time, adequately attenuate the noise generated in such compression process, mainly generated by the pressure fluctuations in the valves.

Such pressure fluctuation produces transients in the holes, which, when reaching the cavity and the compressor housing, generate low and high frequency noises of varied amplitude and that, generally, will be responsible for the total noise of the compressor and by customer complaints due to that noise.

## OBJECTIVES OF THE INVENTION

It is an objective of the present invention to allow the refrigerant to reach the suction valve at low temperature.

It is another objective of the present invention to reduce the load loss in the process of refrigerant compression.

It is still another objective of the present invention to improve the noise attenuation generated in the compression process.

It is still another objective of the present invention the correct positioning of the suction system in the equipment.

It is important to note that there are advantages in the manufacturing process of the filter (productive process) due to the format and arrangement of the resonators, *i.e.,* those having vertical direction of mold extraction in the aperture direction of the body and of the filter lid would have such advantages. As acoustic filters are needed in all compressors, dimensional stability is very important to ensure the repeatability of its response and, thus, in a manufacture process in which thousands of filters are produced, the geometry of easy extraction of the resonators helps in the stability of the process and, consequently, in the quality of the component.

It is possible to maintain the present inventive concept of the filter for multi-volume filters once slight changes in the cavities are made, for example, it can be or not be removed the resonator tubes and added one or more partitions to increase the number of chambers without deviate from the same inventive concept. Thus, the two-volume or multi-volume filter option does not impair the use of the resonators, even if such modifications lead to a different acoustic response, which can be corrected by means of the relocation of the resonators so as to obtain the best acoustic performance. For example, in the two-volume filter, the placement of resonators can occur in both volumes or in only one of them, if there is the necessary attenuation.

## SUMMARY OF THE INVENTION

The present invention refers to a resonator element in a suction filter for a hermetic compressor, the said filter comprising at least one volume, two tubes, an inlet nozzle and an outlet nozzle, said resonator element being located internally the filter at its upper part and being formed by at least two ducts with varying lengths determined by the values and by the amount of frequencies to be attenuated. It is noted that the ducts are adjacently arranged aligned with each other and have a symmetrical shape therebetween, and in addition, three or more ducts have lengths harmonically increasing or decreasing with respect to each other.

The set of resonant ducts comprises at least one duct with a length L, which is determined by the equation

$$f = i.\frac{v}{4L}$$

In which f = frequency, v = density, L = tube length and i = a harmonic number.

The physical characteristics of the resonant duct are defined according to the dimensions and geometry of the suction filter volume, as well as the density of the refrigerant gas to be used.

The dimensions and geometry of the suction filter volume comprise the length of the first tube and the distance formed between the filter lid and the lower wall of the volume. The number of resonant ducts is directly related to the frequency bandwidth and to the amount of frequencies that it is desired to attenuate, depending on the available internal space of the filter.

The positioning of the ducts in the filter volume is defined by the wave pressure variation of the resonance frequency that will be attenuated. The material of its constitution and of the suction filter is plastic with special characteristics in function of the temperature or any material with low thermal conductivity. It is noted that the suction filter may have more than one volume. The ducts are originally molded in the filter lid or mounted as an independent component, fixed to the upper part of the filter.

The present invention also refers to a method of making a resonator element comprising: performing an acoustic simulation in a software to determine the geometric position of the resonators within the filter in function of the location of the frequencies to be attenuated; provide an excitation at the inlet of the filter, which represents the pressure variation in the suction valve; determine the response function in frequency of the filter; and locate in which frequency band and at which filter location this frequency band shows its maximum and minimum wavering of the sound pressure.

The method further comprises the step of determination of the length of the resonator element L by the equation

$$f = i.\frac{v}{4L}$$

In which f = frequency, v = density, L = tube length and i = a harmonic number.

## DESCRIPTION OF THE INVENTION

The present invention refers to the use of a resonant system by a set of ducts positioned internally the upper part of the filter so as to enable the correct functioning of the suction system and reduce the noise of the compressor. Alternatively, different formatting can be used to the set of resonant tubes, which are, preferably, originally molded in the filter lid. For example, they may also be, in a coupled form or as an independent component, attached to the upper part of the filter, so as to enable tuning at any frequency of interest. This attachment can be obtained by snap-on type fit or by any adhesive element that allows the correct attachment of the set and that holds the position after transport test.

Preferably, the material of the suction filter is plastic with special characteristics in function of the temperature, but it can be of any material with low thermal conductivity. The main characteristic that the material used in the filter shall possess is its ability to reproduce different formats, *i.e.,* its ability to be molded. Nowadays, it can now be found filters of plastic, PBT, aluminum, steel, etc.

About how the resonators assembly operates, in order to understand its functioning, it is important to note that when the frequency of oscillation of the source coincides with the frequency of natural oscillation of the body, the amplitude of oscillation of that body reaches high values. As mentioned earlier, this phenomenon is known as resonance. As it is known, in the case of sound waves, the pressure varies depending on how the molecules are arranged in their equilibrium position. The stationary wave concept can be used to determine the resonance of a refrigerant column, which is nothing more than a resonator medium. Suppose that, when the assembly is conventionally mounted in the filter, we have the refrigerant column (which is the resonator itself) opened at the lower part and closed at the upper part.

When such column is at its natural frequency and is excited by a tuning fork or other pure-tone generating device, it will resonate (it is possible to hear a loud sound). The resonance frequency of the column is reached when its length is such that the anti-node occurs in the aperture where the air molecules are free to vibrate, and the node occurs in the closed part of the column where the air molecules are not allowed to vibrate.

A standard suction filter, due to the constructive characteristics of tubes and volumes, presents internal resonances that can amplify (increase) the noise generated in the compression process of the refrigerant gas. These resonances, which depend on the geometric characteristics of the tubes (diameter and length) and the volume (internal dimensions), will be attenuated by the presence of the set of resonators that is the object of this patent.

The frequencies of internal resonances are derived from physical characteristics defined according to the dimensions and geometry of the volume, as well as by the density of the refrigerant gas to be used, which demands that for each constructive filter assembly and its application, a distinct set of resonators should be required so that the (inadequate) frequency in the filter is attenuated.

It is noted that the velocity of a wave depends on the properties of the medium in which it propagates. For sound waves in a fluid, the velocity varies according to the density of the fluid (inertial property) and the bulk modulus (elastic property). The equation below shows how to calculate the velocity in any fluid, in this case a refrigerant gas:

$$v = \sqrt{B/\rho};$$

in which v is the velocity of the wave (m/s); B is the bulk modulus (Pa); and p is the specific mass of the medium (Kg/m$^3$)

It is important to highlight that the internal excitations in the acoustic filters have broadband characteristics, that is, they occupy a region of several frequencies, consequently, the attenuation cannot occur in a single frequency (also called pure tone or narrow band), but in several frequencies that compose the band known as broadband. These broadband frequencies occur primarily due to internal damping and filter geometry itself.

Commonly used frequency bands are known as 1 octave and 1/3rd octave. The 1/3rd octave bands are the most employed in the refrigeration industry and have by definition a central frequency, a lower limit frequency and a higher limit frequency. For example, the 1/3rd octave band of 2,500 Hz will be used herein, in which the central frequency is 2,500 Hz, the lower limit frequency set by 2,239 Hz and the upper limit frequency set by 2,818 Hz. That is, in the present invention attenuating the frequency of the 2,500 Hz band means to attenuate in a region ranging from 2,239 Hz to 2,818 Hz and, for this reason, there is a need for a minimum number of resonators to cover such a frequency band.

With the tuning of resonators (refrigerant columns), it is possible to tune to a broadband frequency band and thus avoid possible low and high frequency problems in the noise spectrum, which will depend on the size and position of the resonators.

It is important to note that the problem regarding the load loss is solved by the non-use of tubes directly located in the passage of the refrigerant fluid, so as not to restrict the flow of refrigerant by the variation in diameters and lengths commonly used in this type of filter for attenuating noise. The correct positioning of the tubes in the filter volume also contributes to the reduction and elimination of the load loss, for it produces an adequate flow and volume to the refrigerant to be compressed. The positioning is defined by the wave pressure variation of the resonance frequency that will be attenuated.

The extension of the resonant tubes allocated at the upper part of the filter (known as the filter lid) is also beneficial from the point of view of the refrigerant flow, as it does not create vertices and turbulences in the volume, as it reduces the total impedance of the passive circuit. The extent of each resonant tube is determined by the length of the frequency of interest.

The manufacture of a set of resonators, which is the object of the present invention, begins by acoustic simulation software, for example, Ansys. Such simulation is performed to determine the geometric position of the resonators within the filter according to the location of the frequencies that are desired to mitigate. In the software it is defined: a) an excitation at the filter inlet so as to represent the pressure variation in the suction valve; and b) it is determined the response function in frequency of the filter, it being possible to locate in which frequency band, and at which filter site such frequency band shows its maximum and minimum fluctuation of the sound pressure.

The frequency band defines the number of resonators that will be used as a function of their width, *i.e.*, a low frequency band of 630 Hz type presents a width of 146 Hz, as to a high frequency band of 2,500 Hz type has a width of 579 Hz and, thus, more frequencies need to be tuned and, consequently, more resonators are needed. Concomitantly, the design of each resonator tube will be determined according to the space available in the internal filter space, and the frequency band that it will perform by the main geometric parameter of length L.

The length of the tubes aligned with the resonators maximizes the acoustic attenuation of the filter, besides of facilitating its mounting, for it provides a solid base as a reference for such mounting. The alignment, *i.e.*, the arrangement of a tube next to the other, as well as the proximity between them, allows tuning several frequencies generated in the suction process. For example, a frequency (f) needs a length tube (L) according to the equation of open closed tube configuration resonance.

$$f = i \cdot \frac{v}{4L}$$

In which f = frequency, v = density, L = tube length and i = a harmonic number.

As an example, using the above equation for a compressor frequency around the 1/3 octave band of 2,500 Hz (covering a band of 2,239 Hz as lower limit and 2,818 Hz as upper limit), tubes with lengths as described below will be necessary, for a refrigerant of type R600A (for other refrigerants depending on the density other lengths of tubes will be needed) being used at a temperature around 70 degrees Celsius. The refrigerant temperature will set the density to be used, so that it will be found:

f1 = 2,239 Hz, f2 = 2,400 Hz, f3 = 2,500 Hz (Central frequency), f4 = 2,600 Hz and f5 = 2,818 Hz

L1 = 23.1 mm, L2 = 24.1 mm, L3 = 25.1 mm, L4 = 26.1 mm e L5 = 27.1 mm

It is here exemplified a set of 5 resonators only to demonstrate the application of the project ranging from 23.1 to 27.1 mm in length and that will attenuate a frequency band between 2,239 Hz to 2,818 Hz. The resonator f1 was calculated for the start of the band, the second and the fourth resonators (f2 and f4) were positioned near to the central frequency. The resonator f3 was calculated exactly in the center of the band and, finally, the resonator f5 was positioned at the end of the band covering the entire band.

The greater the number of resonators greater the coverage on the frequency and hence, greater the possibility of attenuating the noise spectrum region.

**BRIEF DESCRIPTION OF THE FIGURES**

Figure 1 illustrates a representation of a mass-spring system that behaves in a manner equivalent to the acoustic resonator.

Figure 2 illustrates a suction filter from the Brazilian prior art.

Figure 3 illustrates the opaque representation of a suction filter considering the main external constructive aspects of the filter.

Figure 4 shows a cutting representation of a filter of the state of the art.

Figure 5 is another cutting view in which the resonators are positioned on the lid relative to the internal volume of the filter.

Figure 6 shows a superior view illustrating the geometric symmetry between the resonant tubes.

Figure 7 is an isometric view showing the positioning of the resonating tubes detached from the filter body and positioned on the upper lid.

Figure 8 illustrates a lower perspective view of the resonators.

Figure 9 shows a side view of the resonators.

Figure 10 illustrates a new disposition of resonators.

Figure 11 shows a two-volume filter.

## DESCRIPTION OF THE DRAWINGS

In Figure 1 it is observed a representation of a mass-spring system that behaves in a manner equivalent to the acoustic resonator. In which the pressure *p0* on the neck of the tube behaves like the mass m, and volume *v0* as a spring *k* of the system. With the tuning of resonators (refrigerant columns), it is possible to tune to a broadband frequency band and, thus, avoid possible low and high frequency problems in the noise spectrum, which will depend on the size and position of the resonators.

In Figure 2, a representation of the Brazilian prior art is shown, in which the positioning of an arrangement of resonators in the filter body is observed, wherein these resonators of circular format, spaced from each other and with varying and non-symmetrical lengths. One of the problems that such filter face, with such resonant ducts, due to its location and non-symmetrical sizes, is the turbulence and the fact that the used refrigerant clogs the ducts and prevent an adequate attenuation from being proportionate.

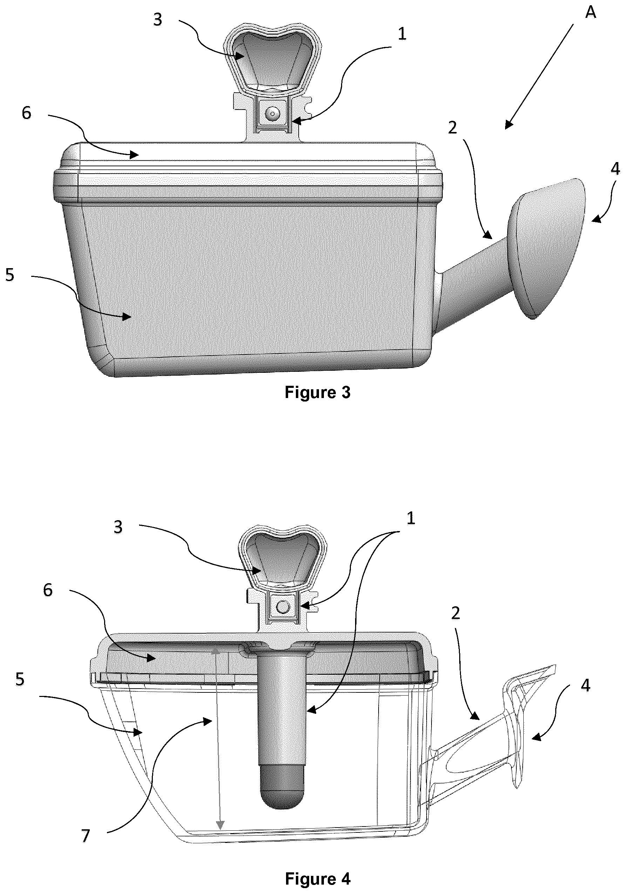

In Figure 3, it can be seen the suction filter representation considering the main constructive aspects of the filter with the arrangements of tubes and volumes in the form of external representation. For simplicity, the setting of a volume and two tubes is illustrated, wherein the first tube 1 is located at the suction inlet and the second tube 2 is in the filter outlet, so as to represent the concept of passive filter. Elements 3 and 4 are, respectively, the inlet and outlet holes of the filter under the noise point of view. The numbers 5 and 6 refer to the body and filter lid, respectively.

In Figure 4, a cut representation of the filter can be seen, showing the volume arrangement and proportions 7 (indicated by a line) that define the length of the first tube 1. In this figure, the elements 3 and 4 and the body 5 and the filter lid 6 are illustrated.

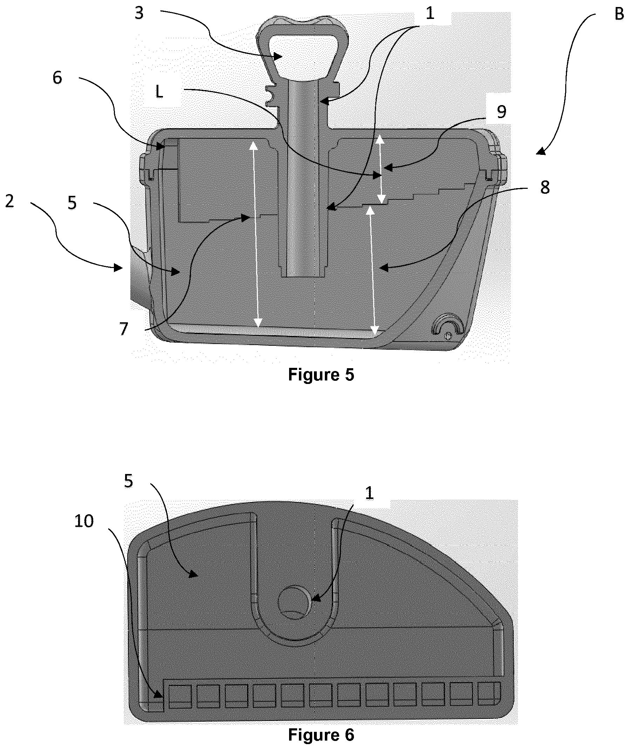

When the filter is in operation, the noise generated at the filter inlet 3, due to the pressure fluctuation in function of the suction valve opening and the density of the refrigerant used, propagates through the first tube 1 reaching the volume 5 by pressure waves. These pressure waves, which propagate the noise, are attenuated in the ducts 9 (see fig. 5) due to the impedance modification between the volume 5 and the resonant tubes/ducts 9. For each length of the first tube 1 and the distance 7 formed between the lid 6 and the lower wall of volume 5, internal resonances are created that will require attenuation.

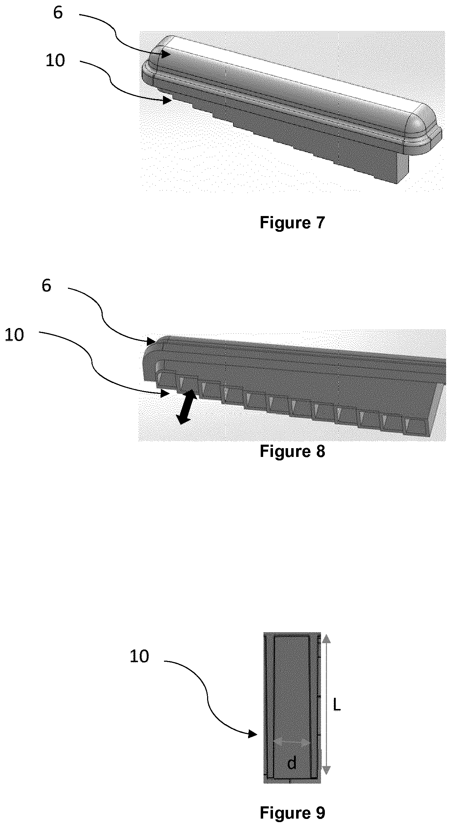

In Figure 5, another cut view can be seen, in which the resonators 9 are positioned relative to the internal volume 5 creating a relative distance between them. That is, the height L of the resonators 9 varies, as well as the distance 8 between its opened ends and the bottom of the filter. The height L of the resonators 9 and its diameter define the frequency of the resonator (shown in Figure 9) that will be attenuated.

Figures 6, 7 and 8 illustrate the set 10 of resonators 9 positioned in the filter and also highlighted. The top view in Figure 6 shows the geometric symmetry between the tubes. Figure 7 is an isometric view showing the positioning of the resonant tubes detached from the filter body and positioned on the upper lid 6 of it. In the lower perspective view in Figure 8, it is also defined therein the various lengths of the resonators in function of the equivalent resonance. The idea of the amount of tubes forming the set of resonators 10 is also shown in Figure 8. It is noted that the quantity of tubes depends on the available space and the frequency band that it is desired to attenuate.

The height L of the resonators 9 defines the frequency of the resonator shown in Figure 9. In general a set 10 of resonators 9 will have between 10 and 15 tubes to cover a 500 Hz region in the frequency band. The greater the number of resonators 9, the greater the coverage of the frequency band and, hence, the greater the attenuation.

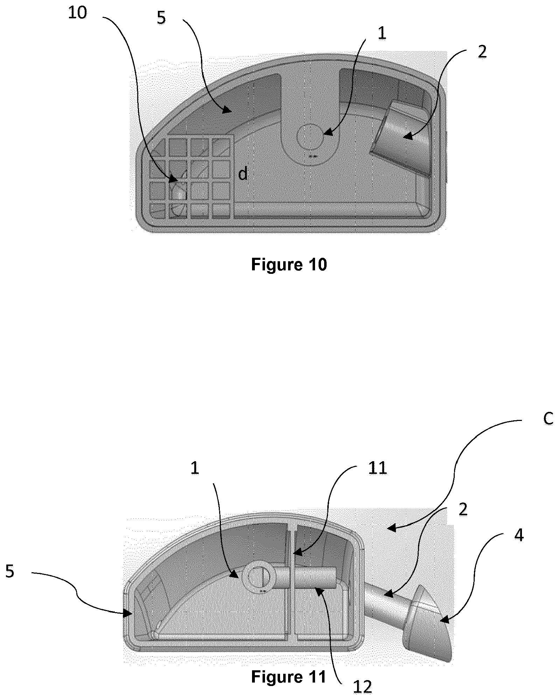

In Figure 10, a new arrangement of a set 10 of resonators is shown in order to represent the various possibilities of arrangement of tubes 9, which can be used to seek the desired attenuation. A set 10 of resonators 9 in square format exemplifies this possibility, this format can be extended to any format that allows for its production and the arrangement of the resonant tubes 9 side by side. That is, the format is important for it will define the attenuation that will be necessary and, consequently, the region where the set 10 of resonants 9 will act as already described and identified by simulation. It is understood by region the set of frequencies that is sought to attenuate, *i.e.*, the attenuation frequency band, which in the typical compressor is located between 2500 and 4000 Hz.

Finally, Figure 11 shows that the filter is not restricted to the use of only one volume 5, but which can be formed by several volumes 5. An example with one volume 5 was described and presented in several figures from 3 to 10. In Figure 11 a filter (C) is illustrated with first 1 and second 2 tubes and an outlet hole 4, wherein the said filter has two volumes 5 and is presented with the introduction of a barrier 11 and a third tube 12, which in this way, create other volumes that would form other resonances and would define another set 10 of resonators 9 to attenuate them. With the introduction of the barrier 11 to create other volumes, the filter's internal resonances will be altered and a new set 10 of resonators 9 will be required to attenuate this new frequency and/or frequency band. This new determination is made by simulation using the software already described and the new geometric format of the filter.

Having described examples of preferred embodiments, it is to be understood that the scope of the present invention encompasses other possible variations, being limited only by the content of the attached claims, including possible equivalents thereto.

**Claims**

1. RESONATOR ELEMENT (9) in a suction filter (B, C) for a hermetic compressor, the said filter comprising at least one volume (5), two tubes (1, 2), an inlet nozzle (3) and an outlet nozzle (4), the said resonator element (9) **characterized by** the fact that it is located internally the filter (B) at its upper part (6) and it is formed by at least two ducts (9) with varying lengths determined by the values and by the amount of frequencies to be attenuated.

2. ELEMENT, according to the claim 1, **characterized by** the fact that the ducts (9) are adjacently arranged aligned with each other and have a symmetrical format between them.

3. ELEMENT, according to the claim 1, **characterized by** the fact that three or more ducts (9) have harmonically increasing or decreasing lengths between each other.

4. ELEMENT, according to the claim 1, **characterized by** the fact that the set (10) of resonant ducts (9) comprises at least two ducts (9) with lengths L determined by the equation

$$f = i.\frac{v}{4L}$$

in which f = frequency, v = density, L = tube length and i = a harmonic number.

5. ELEMENT, according to the claim 1, **characterized by** the fact that physical characteristics of the resonator duct (9) are defined in function of the dimensions and geometry of the volume (5) of the suction filter (B), as well as the density of the refrigerant gas to be used.

6. ELEMENT, according to the claim 5, **characterized by** the fact that the dimensions and geometry of the suction filter volume comprise the length of the first tube (1) and the distance (7) formed between the lid (6) of the filter and the lower wall of the volume (5).

7. ELEMENT, according to the claim 1, **characterized by** the fact that the number of resonant ducts (9) is directly related to the bandwidth of the frequency and to the amount of frequencies, which are desired to be attenuated, in function of the available internal space of the filter (B).

8. ELEMENT, according to the claim 1, **characterized by** the fact that the positioning of the ducts (9) in the volume (5) of the filter is defined by the wave pressure variation of the resonance frequency that will be attenuated.

9. ELEMENT, according to the claim 1, **characterized by** the fact that the material of its constitution and suction filter is plastic with special characteristics in function of the temperature or any material with low thermal conductivity.

10. ELEMENT, according to the claim 1, **characterized by** the fact that the suction filter (C) can present more than one volume (5).

11. ELEMENT, according to the claim 1, **characterized by** the fact that the ducts (9) are originally molded into the lid (6) of the filter (B, C).

12. ELEMENT, according to the claim 1, **characterized by** the fact that the ducts are mounted as an independent component, fixed to the upper part (6) of the filter (B, C).

13. METHOD FOR THE MANUFACTURE OF A RESONATOR ELEMENT, **characterized by** the fact that it comprises:

    performing an acoustic simulation in a software to determine the geometric position of the resonators within the filter in function of the location of the frequencies that are desired to mitigate; providing an excitation in the filter inlet representing the pressure variation in the suction valve;
determining the response function in frequency of the filter; and
locating in which frequency band and at which filter location such frequency band presents its maximum and minimal acoustic pressure fluctuation.

14. METHOD, according to the claim 13, **characterized by** comprising the step of determining the length of the resonator element L by the equation

$$f = i.\frac{v}{4L}$$

in which f = frequency, v = density, L = tube length and i = a harmonic number.

**Figure 1**

**Figure 2**

Figure 3

Figure 4

**Figure 5**

**Figure 6**

6

10

**Figure 7**

6

10

**Figure 8**

10

L

d

**Figure 9**

**Figure 10**

**Figure 11**

Europäisches
Patentamt

European
Patent Office

Office européen
des brevets

# EUROPEAN SEARCH REPORT

Application Number

EP 17 19 3744

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | WO 2007/124552 A1 (WHIRLPOOL SA [BR]; BAARS EDMAR [BR]; MIGUEL EDSON CORREA [BR]) 8 November 2007 (2007-11-08) * abstract *; figures 8-12 * * page 8, line 32 - page 13, line 11 * ----- | 1-14 | INV. F04B39/00 |
| A | JP 2003 166689 A (TOKYO GAS CO LTD) 13 June 2003 (2003-06-13) * abstract *; figures * ----- | 1-14 | |
| A | JP H02 102313 A (SANKYO KOGYO KK; IMAI KAZUYOSHI) 13 April 1990 (1990-04-13) * abstract *; figures * ----- | 1-14 | |

TECHNICAL FIELDS
SEARCHED (IPC)

F04B

The present search report has been drawn up for all claims

| Place of search | Date of completion of the search | Examiner |
|---|---|---|
| Munich | 23 January 2018 | Pinna, Stefano |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 17 19 3744

This annex lists the patent family members relating to the patent documents cited in the above-mentioned European search report.
The members are as contained in the European Patent Office EDP file on
The European Patent Office is in no way liable for these particulars which are merely given for the purpose of information.

23-01-2018

| Patent document cited in search report | | Publication date | Patent family member(s) | | Publication date |
|---|---|---|---|---|---|
| WO 2007124552 | A1 | 08-11-2007 | BR PI0601716 A | | 18-12-2007 |
| | | | CN 101466949 A | | 24-06-2009 |
| | | | EP 2013480 A1 | | 14-01-2009 |
| | | | ES 2440490 T3 | | 29-01-2014 |
| | | | JP 5404387 B2 | | 29-01-2014 |
| | | | JP 2009535558 A | | 01-10-2009 |
| | | | US 2009178881 A1 | | 16-07-2009 |
| | | | WO 2007124552 A1 | | 08-11-2007 |
| JP 2003166689 | A | 13-06-2003 | NONE | | |
| JP H02102313 | A | 13-04-1990 | NONE | | |

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2000052333 A1
- WO 2011147005 A1
- WO 2008098330 A
- BR 06017169